# EUROPÄISCHE PATENTSCHRIFT

(11) **EP 0 497 129 B1**
(45) Veröffentlichungstag und Bekanntmachung des Hinweises auf die Patenterteilung: **26.07.1995**
(21) Anmeldenummer: 92100428.9
(22) Anmeldetag: 13.01.1992
(51) Int. Cl.: H05K 13/04

(54) **Vorrichtung zum Bestücken von Leiterplatten**
Device for equipping of circuit boards
Dispositif pour équiper des plaquettes de circuits

(30) Priorität: 28.01.1991 DE 4102461
(43) Veröffentlichungstag der Anmeldung: 05.08.1992
(73) Patentinhaber: SIEMENS AKTIENGESELLSCHAFT, 80333 München (DE)
(72) Erfinder: Gromer, Kurt, Dipl.-Ing., W-7527 Kraichtal (DE); Haan, Franz, Dipl.-Ing., W-7520 Bruchsal (DE); Jung, Werner, W-6833 Wäghäusel (DE); Pedall, Friedrich, Dipl.-Ing., W-7528 Karlsdorf (DE)

(56) Entgegenhaltungen:
- GB-A- 2 025 804
- US-A- 4 197 637
- ELONCO BULLETIN Nr. 120, Oktober 1984, EINDHOVEN NEDERLAND Seiten 3 - 9; 'SMA-SURFACE MOUNTED ASSEMBLY'

## Beschreibung

Das Bestücken von Leiterplatten mit elektrischen oder elektronischen Bauelementen wird entweder manuell oder mit Hilfe von Bestückautomaten vorgenommen. Bei bedrahteten Bauelementen wird bei allen Bestückvorgängen das einzelne Bauelement in einem eigenen Arbeitsschritt für den späteren Bestückschritt vorbereitet. Anschließend werden die bedrahteten Bauelemente in für das betreffende Bauelement vorhandene Bohrungen der Leiterplatte gesteckt. Bei unbedrahteten Bauelementen, den sogenannten SMD-Bauelementen, werden die einzelnen Bauelemente lagegenau in Klebepunkte oder in Lötpaste gedrückt. Dabei erfolgt das Aufbringen der Klebepunkte oder der Lötpaste in einem vorausgehenden Arbeitsschritt.

Bei bedrahteten Bauelementen werden die an der Unterseite der Leiterplatte herausragenden Anschlußdrähte der Bauelemente nach dem Bestückvorgang in der Regel auf eine funktionsgerechte Länge abgeschnitten. Ein Herausfallen der Bauelemente wird durch Umbiegen der Anschlußdrähte an der Rückseite der Leiterplatten verhindert.

Bei bekannten Vorrichtungen zum Bestücken von Leiterplatten wird das Bauelement mit einem Bestückkopf von einem Bauelemente-Verarbeitungs- und Prüfplatz gegriffen und lagegenau für den späteren Bestückvorgang im Bestückkopf zentriert. Beim Bestücken von Leiterplatten mit SMD-Bauelementen positioniert in der Regel ein X/Y-Koordinatentisch den Bestückkopf mit dem Bauelement über die vorgegebene Bestückposition auf der feststehenden Leiterplatte. Bei Vorrichtungen zum Bestücken von Leiterplatten mit bedrahteten Bauelementen, die ein Unterwerkzeug zum Ablängen und Umbiegen der Anschlußdrähte benötigen, wird die Leiterplatte mit einem in X- und Y-Richtung verschiebbaren Kreuztisch unter den feststehenden Bestückkopf bewegt. In beiden Fällen wird der Bestückvorgang dann durch eine Absenkbewegung des Bestückkopfes durchgeführt, mit welcher das jeweilige Bauelement lagegenau auf der Leiterplatte positioniert wird.

Bei einigen in Robotertechnik ausgeführten Bestückautomaten bewegen sich Bestückkopf und Unterwerkzeug in die Bestückposition auf der fest angeordneten Leiterplatte.

Ein Nachteil der bisher am Markt vorhandenen Bestückautomaten liegt im seriellen Ablauf der Bauelementevorbereitung, der Bauelementeprüfung, des Greifens der Bauelemente und des Bestückens der Bauelemente, wobei dieser serielle Ablauf durch die Verwendung von nur einem Bestückkopf pro Maschine bedingt ist.

Es sind auch Vorrichtungen mit einem als Revolverkopf ausgebildeten Mehrfachbestückkopf bekannt, der an einem X/Y-Koordinatenantrieb befestigt ist. Durch eine Bauelemente-Aufsammelbewegung mit anschließender Bauelemente-Bestückfunktion dieses Mehrfachbestückkopfes kann hier der serielle Bestück-Vorgang zeitlich stark reduziert werden. Das mit einer derartigen Vorrichtung verarbeitbare Bauelementespektrum ist jedoch durch die räumliche Begrenzung des Positioniersystems, bezogen auf eine Bestückposition, stark eingeschränkt. Der für das Bestücken von Leiterplatten mit bedrahteten Bauelementen erforderliche Einsatz von Unterwerkzeugen ist bei derartigen Werkzeugen funktionell nicht möglich.

Aus der EP-A-0 389 048 ist eine Vorrichtung zum Bestücken von Leiterplatten mit Bauelementen bekannt, die mehrere, im Abstand zueinander angeordnete Bestückmodule besitzt. Die Bestückmodule sind mit Bestückköpfen zum Positionieren der Bauelemente an vorgegebenen Bestückpositionen auf den Leiterplatten ausgerüstet. Jedem Bestückkopf sind jeweils mehrere auf einem Träger angeordnete Leiterplatten zugeordnet, wobei sämtliche Träger auf einer gemeinsamen Träger-Verschiebeeinrichtung simultan nach dem gleichen Bewegungsmuster derart verfahren werden, daß die jeweils auf einem Träger angeordneten Leiterplatten nacheinander in einander entsprechende Bestückpositionen gebracht werden. Dabei wird nach jedem Verschiebevorgang der Träger-Verschiebeeinrichtung von jedem Bestückkopf ein Bestückvorgang ausgeführt. Nach jedem Bestückzyklus werden mit Hilfe einer Träger-Transporteinrichtung die Träger zum nächsten Bestückmodul transportiert, wobei dem ersten Bestückmodul ein Träger mit unbestückten Leiterplatten zugeführt wird und vom letzten Bestückmodul ein Träger mit fertig bestückten Leiterplatten abgeführt wird.

Bei sämtlichen bekannten Bestückautomaten handelt es sich um auf bestimmte Bauelementetypen reduzierte Speziallösungen. Für das gesamte elektrische und elektronische Bauelementespektrum ist dementsprechend eine Vielzahl von Bestückautomaten erforderlich, die einen völlig verschiedenen Grundaufbau besitzen. Die Bestückzeiten dieser Bestückautomaten liegen in der Regel bei mehreren Sekunden pro Bauelement, sofern die Leiterplattenwechselzeiten in den Bestückablauf einberechnet werden.

Der im Anspruch 1 angegebenen Erfindung liegt das Problem zugrunde, eine flexible Vorrichtung zum Bestücken von Leiterplatten zu schaffen, mit welcher das gesamte Bauelementespektrum mit wirtschaftlich sehr kurzen Bestückzeiten verarbeitet werden kann.

Bei der erfindungsgemäßen Vorrichtung ist eine räumliche Aufteilung der Bauelementebestückung auf mehrere in ihrer Funktion eigenständig arbeitende Bestückmodule vorgesehen. Jedem dieser Bestückmodule ist dabei eine Leiterplatte zugeordnet, wobei sämtliche dieser Leiterplatten auf einer in X- und Y-Richtung verfahrbaren Leiterplatten-Verschiebeeinrichtung befestigt sind, die gemeinsam mit allen Leiterplatten programmgesteuerte Bestückbewegungen ausführt. Fährt diese Leiterplatten-Verschiebeeinrichtung dabei einen Eichpunkt mit frei wählbaren X/Y-Koordinaten an und fahren in dieser Stellung sämtliche Bestückköpfe auf die ihnen zugeordneten Leiterplatten, so treffen alle Bestückköpfe mit ihrer Mittelachse jeweils den gleichen Koordinatenpunkt der den Bestückmodulen zugeordneten Leiterplatten. Mit der Leiterplatten-Verschiebeeinrichtung können somit sämtliche Bestückkoordinaten einer Leiterplatte abgefahren werden, wobei bei Erreichen dieser Bestückkoordinaten der betreffende Bestückkopf aktiviert wird und somit das gesamte Bestückvolumen einer Leiterplatte seriell nacheinander gesetzt wird. Das Bestückvolumen ist dabei jedoch räumlich getrennt auf die den Bestückmodulen zugeordneten Leiterplatten verteilt. Von entscheidender Bedeutung ist hierbei auch die Möglichkeit, daß jede Bestückposition einzeln, softwaremäßig geändert werden kann.

Werden sämtliche den Bestückmodulen zugeordnete Leiterplatten mit einer Leiterplatten-Transporteinrichtung um eine Modulteilung weitergetaktet, sobald das Bestückprogramm abgearbeitet ist, so wird schrittweise mit jedem Takt etwas mehr Bestückvolumen pro Leiterplatte aufgebracht. Eine Leiterplatte ist dann fertig bestückt, wenn sie an allen Bestückmodulen vorbeigetaktet ist. Die Taktbewegung wird auch für das Be- und Entladen der Vorrichtung benutzt, d. h. bei jedem Takt wird eine unbestückte Leiterplatte zugeführt und eine fertig bestückte Leiterplatte abgeführt.

Die mit der Erfindung erzielbaren Vorteile bestehen insbesondere darin, daß das räumlich getrennte, serielle Bestücken einer Leiterplatte ein paralleles Nachladen der Bestückköpfe ermöglicht, wenn diese nicht aktiv einen Bestückvorgang ausführen. Währen dieser Zeitspanne können die eigenständig arbeitenden Bestückmodule auch die Vorbereitung der einzelnen Bauelemente für den späteren Bestückschritt vornehmen.

Vorteilhafte Ausgestaltungen der Erfindung sind in den Ansprüchen 2-12 angegeben.

Die Ausgestaltung nach Anspruch 2 betrifft eine besonders einfache Ausbildung der Leiterplatten-Verschiebeeinrichtung als Kreuztisch.

Die Ausgestaltung nach Anspruch 3 betrifft eine einfach aufgebaute Leiterplatten-Transporteinrichtung, deren Takt- und Fixierzangen gleichzeitig auch noch eine sichere Fixierung der Leiterplatten bei den Bestückvorgängen ermöglichen. Dabei ist es besonders günstig, wenn gemäß Anspruch 4 der Leiterplatten-Führungsschiene eine Leiterplatten-Zuführschiene und eine Leiterplatten-Abführschiene zugeordnet werden. Gemäß Anspruch 5 wird durch eine in der Breite verstellbare Leiterplatten-Führungsschiene die Verarbeitung verschiedener Leiterplattengrößen ermöglicht.

Die Ausgestaltung nach Anspruch 6 ermöglicht eine optimale Anpassung der jeweils eingesetzten Bestückmodule an verschiedene Bau- und Ausführungsformen von elektrischen und elektronischen Bauelementen.

Die Ausgestaltung gemäß Anspruch 7 bietet die Möglichkeit, jedem einzelnen Bestückmodul wahlweise eine Vielzahl von verschiedenen, konstruktiv aber ähnlichen Bauelementen zuzuführen. Hierdurch kann bei einer gleichbleibenden Anzahl von Bestückmodulen die Anzahl der mit der Vorrichtung verarbeitbaren Bauelemente erheblich vergrößert werden.

Die Ausgestaltung gemäß Anspruch 8 ermöglicht ein äußerst genaues programmgesteuertes Anfahren von Abholpositionen und Übergabeposition.

Gemäß Anspruch 9 wird als endloser Trieb vorzugsweise ein Zahnriemen verwendet, der bei hinreichender Genauigkeit wesentlich wirtschaftlicher als Ketten und dergleichen eingesetzt werden kann.

Die Verwendung von heb- und senkbaren zangenförmigen Greifern als Transportorgan gemäß Anspruch 9 stellt ebenfalls eine besonders einfache und wirtschaftliche Lösung dar.

Die Ausgestaltung nach Anspruch 11 ermöglicht eine Vorbereitung der jeweiligen Bauelemente innerhalb des jeweiligen Bestückmoduls und damit eine äußerst raumsparende, kompakte Ausbildung der gesamten Bestückvorrichtung.

Gemäß Anspruch 12 kann durch die Anordnung einer zusätzlichen Station zum Bearbeiten oder Prüfen der Bauelemente eine weitere Steigerung der Flexibilität erzielt werden. Zur Vermeidung von Taktzeitverlusten wird diese zusätzliche Station dann allerdings nicht wie die Abholpositionen und die Übergabeposition unabhängig programmgesteuert angefahren.

Ausführungsbeispiele der Erfindung sind in der Zeichnung dargestellt und werden im folgenden näher beschrieben.

Es zeigen:
- Fig. 1: das Funktionsprinzip einer erfindungsgemäßen Vorrichtung zum Bestücken von Leiterplatten,
- Fig. 2: eine entsprechend dem in Fig. 1 dargestellten Funktionsprinzip aufgebaute Vorrichtung zum Bestücken von Leiterplatten in perspektivischer Darstellung,
- Fig. 3 und Fig. 4: eine Transporteinrichtung für die Zufuhr von Bauelementen zu einem Bestückkopf der Vorrichtung gemäß Fig. 2 in der Abholposition eines Transportorgans bzw. in der Übergabeposition eines Transportorgans,
- Fig. 5: einen Bestückkopf der Vorrichtung gemäß Fig. 2 mit einer integrierten Bauelement-Richt- und Drehstation,
- Fig. 6: eine gemäß den Fig. 3 und 4 aufgebaute Transporteinrichtung mit drei nebeneinander angeordneten Zuführeinrichtungen für axial bedrahtete, gegurtete Bauelemente und
- Fig. 7: eine gemäß den Fig. 3 und 4 aufgebaute Transporteinrichtung mit zwei nebeneinander angeordneten Flächenmagazinen als Zuführeinrichtungen für verschiedene Bauelemente.

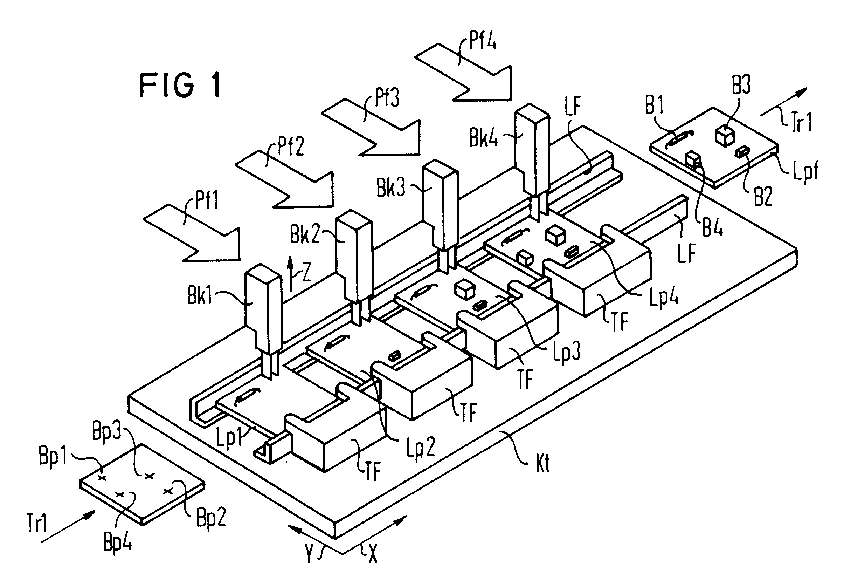

Fig. 1 zeigt in stark vereinfachter schematischer Darstellung eine Vorrichtung zum Bestücken von Leiterplatten mit elektronischen Bauelementen. Es sind vier in jeweils gleichem Abstand zueinander ortsfest angeordnete Bestückköpfe Bk1, Bk2, Bk3 und Bk4 zu erkennen, mit welchen Bauelemente B1, B2, B3 und B4 an vorgegebenen Bestückpositionen Bp1, Bp2, Bp3 und Bp4 auf jeweils zugeordneten Leiterplatten Lp1, Lp2, Lp3 und Lp4 positioniert werden. In Transportrichtung Tr1 der Leiterplatten gesehen ist vor der Vorrichtung eine unbestückte Leiterplatte Lpu mit den durch Kreuze angedeuteten Bestückpositionen Bp1, Bp2, Bp3 und Bp4 zu erkennen, während nach der Vorrichtung eine mit den Bauelementen B1, B2, B3 und B4 fertig bestückte Leiterplatte Lpf aufgezeigt ist. Die Zufuhr der Bauelemente B1, B2, B3 und B4 zu den zugeordneten Bestückköpfen Bk1, Bk2, Bk3 und Bk4 ist durch Pfeile Pf1, Pf2, Pf3 und Pf4 angedeutet. Auf einem in zwei zueinander senkrechten Richtungen X und Y verfahrbaren Kreuztisch Kt sind eine in X-Richtung verlaufende Leiterplatten-Führungsschiene LF und vier den Bestückköpfen Bk1-Bk4 zugeordnete Takt- und Fixierzangen TF angeordnet. In der in Fig. 1 dargestellten Stellung halten die Takt- und Fixierzangen TF die Leiterplatten Lp1-Lp4 in der Leiterplatten-Führungsschiene LF. Die Takt- und Fixierzangen TF haben neben dieser Haltefunktion aber auch noch die Aufgabe, die Leiterplatten in X-Richtung bzw. in Transportrichtung Tr1 in der Leiterplatten-Führungsschiene LF taktweise im Teilungsabstand der Bestückköpfe Bk1-Bk4 zu verschieben.

Die Bestückung der Leiterplatten mit Bauelementen erfolgt in den nachfolgend aufgeführten Bestückschritten:
1. Die Bestückköpfe Bk1, Bk2, Bk3 und Bk4 sind mit den zugeordneten Bauelementen B1 bzw. B2 bzw. B3 bzw. B4 beladen und stehen in Setzstellung. Die den Bestückköpfen Bk1, Bk2, Bk3 und Bk4 zugeordneten Leiterplatten Lp1 bzw. Lp2 bzw. Lp3 bzw. Lp4 sind mit den zugeordneten Takt- und Fixierzangen TF fest in der Leiterplatten-Führungsschiene LF auf dem Kreuztisch Kt gehalten.
2. Der Kreuztisch Kt wird in X- und Y-Richtung verfahren bis sich exakt unter den Bestückköpfen Bk1-Bk4 jeweils die Bestückposition Bp1 auf der jeweils zugeordneten Leiterplatte Lp1-Lp4 befindet. Der Bestückkopf Bk1 wird aktiviert, fährt in Z-Richtung nach unten und setzt ein Bauelement B1 in der Bestückposition Bp1 auf der Leiterplatte Lp1 ab. Die Bestückköpfe Bk2-Bk4 werden bei diesem Schritt nicht aktiviert.
3. Der Kreuztisch Kt wird in X- und Y-Richtung verfahren bis sich exakt unter den Bestückköpfen Bk1-Bk4 jeweils die Bestückposition Bp2 auf der jeweils zugeordneten Leiterplatte Lp1-Lp4 befindet. Der Bestückkopf Bk2 wird aktiviert, fährt in Z-Richtung nach unten und setzt ein Bauelement B2 in der Bestückposition Bp2 auf der Leiterplatte Lp2 ab. Die Bestückköpfe Bk1, Bk3 und Bk4 werden bei diesem Schritt nicht aktiviert.
4. Der Kreuztisch Kt wird in X- und Y-Richtung verfahren bis sich exakt unter den Bestückköpfen Bk1-Bk4 jeweils die Bestückposition Bp3 auf der jeweils zugeordneten Leiterplatte Lp1-Lp4 befindet. Der Bestückkopf Bk3 wird aktiviert, fährt in Z-Richtung nach unten und setzt ein Bauelement B3 in der Bestückposition Bp3 auf der Leiterplatte Lp3 ab. Die Bestückköpfe Bk1, Bk2 und Bk4 werden bei diesem Schritt nicht aktiviert.
5. Der Kreuztisch Kt wird in X- und Y-Richtung verfahren bis sich exakt unter den Bestückköpfen Bk1-Bk4 jeweils die Bestückposition Bp4 auf der jeweils zugeordneten Leiterplatte Lp1-Lp4 befindet. Der Bestückkopf Bk4 wird aktiviert, fährt in Z-Richtung nach unten und setzt ein Bauelement B4 in der Bestückposition Bp4 auf der Leiterplatte Lp4 ab. Die Bestückköpfe Bk1-Bk3 werden bei diesem Schritt nicht aktiviert.

Nach den vorstehend aufgeführten Schritten werden die Leiterplatten in Transportrichtung Tr1 gesehen um eine Teilung weitergetaktet. Dabei wird die unbestückte Leiterplatte Lpu dem Bestückkopf Bk1 zugeordnet, während die Leiterplatten Lp1, Lp2 und Lp3 den Bestückköpfen Bk2 bzw. Bk3 bzw. Bk4 zugeordnet werden. Die nunmehr fertig bestückte Leiterplatte Lp4 wird in Transportrichtung Tr1 ausgeschoben. Die räumlich getrennte, serielle Bestückung der Leiterplatten ermöglicht ein paralleles Nachladen der Bestückköpfe Bk1-Bk4, wenn diese nicht aktiv einen Bestückvorgang ausführen. Dementsprechend sind nach dem Weitertakten sämtliche Bestückköpfe Bk1-Bk4 wieder mit den zugeordneten Bauelementen B1-B4 beladen und der Zustand gemäß Schritt 1 ist wieder erreicht. Für die Leiterplatten Lpu und Lp1-Lp3 schließt sich dann wieder ein Bestückzyklus entsprechend den Schritten 2-5 an.

Gemäß einer Variante der vorstehend beschriebenen Bestückung kann sich an den Bestückschritt 5 gegebenenfalls ein Bestückschritt 6 anschließen, in welchem mit dem Kreuztisch Kt eine weitere, in Fig. 1 nicht dargestellte Bestückposition angefahren wird und mit dem Bestückkopf Bk1 ein zweites Bauelement B1 in dieser Setzposition auf der Leiterplatte Lp1 positioniert wird. Erst danach werden dann die Leiterplatten in Transportrichtung Tr1 um eine Teilung weitergetaktet. Es ist ersichtlich, daß derartige zusätzliche Bestückvorgänge auch von den Bestückköpfen Bk2, Bk3 und Bk4 mit Bauelementen B2 bzw. B3 bzw. B4 ausgeführt werden können. Wie an späterer Stelle noch erläutert wird, können den Bestückköpfen Bk1-Bk4 jeweils auch elektrisch verschiedene aber geometrisch ähnliche Bauelemente zugeführt werden. Diese Bauelemente können dann auch in entsprechenden Bestückvorgängen vor dem Weitertakten der Leiterplatten in zugeordneten Bestückpositionen auf den Leiterplatten positioniert werden. Selbstverständlich kann eine auf dem beschriebenen Prinzip beruhende Bestückung auch mit zwei oder drei oder mit mehr als vier Bestückköpfen vorgenommen werden.

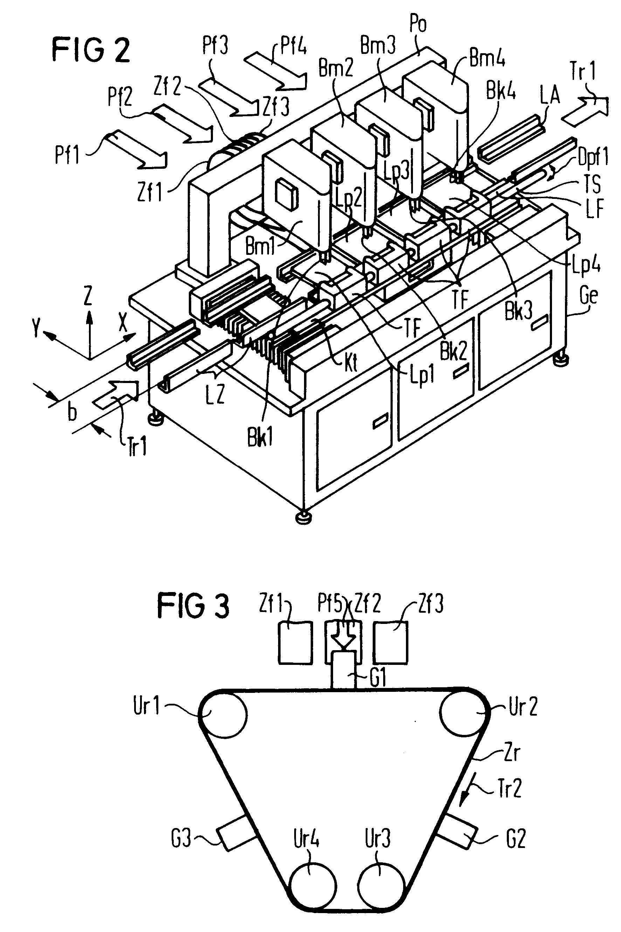

Fig. 2 zeigt eine entprechend dem in Fig. 1 dargestellten Funktionsprinzip aufgebaute Vorrichtung zum Bestücken von Leiterplatten. Es ist zu erkennen, daß der Kreuztisch Kt auf einem kastenförmigen Gestell Ge angeordnet ist, welches in seinem rückwärtigen Bereich ein Portal Po trägt. An diesem Portal Po sind auswechselbar Bestückmodule Bm1, Bm2, Bm3 und Bm4 befestigt, in welchen sich die bereits beschriebenen Bestückköpfe Bk1 bzw. Bk2 bzw. Bk3 bzw. Bk4 befinden. Auf der Rückseite des Portals P sind drei Zuführeinrichtungen Zf1, Zf2 und Zf3 für axial bedrahtete, gegurtete Bauelemente zu erkennen, die dem Bestückmodul Bm1 die jeweils benötigten Bauelemente über eine Transporteinrichtung zuführen, die an späterer Stelle im Zusammenhang mit den Fig. 3-5 näher erläutert wird.

Wie im Zusammenhang mit der Fig. 1 bereits erwähnt wurde, werden die den Bstückmodulen Bm1-Bm4 zugeordneten Leiterplatten Lp1-Lp4 gemeinsam in der Leiterplatten-Führungsschiene LF um eine Modulteilung weitergeschoben, sobald ein Bestückprogramm abgearbeitet ist. Dieser taktweise Vorschub in Transportrichtung Tr1 erfolgt durch die Takt- und Fixierzangen TF, die auf einer in X-Richtung hin- und herbewegbaren Transport-Stange TS angeordnet sind. Zum Fixieren und Lösen der Leiterplatten Lp1-Lp4 können die Takt- und Fixierzangen TF durch Verdrehen der Transport-Stange TS um deren Längsachse in Richtung des Doppelpfeilers Dpf1 geschwenkt werden. Die Taktbewegung der Takt- und Fixierzange TF in X-Richtung wird auch für das Be- und Entladen der gesamten Vorrichtung ausgenutzt. Hierzu sind für die Zufuhr unbestückter Leiterplatten Lpu (vgl. Fig. 1) Leiterplatten-Zuführschienen LZ und für die Abfuhr fertig bestückter Leiterplatten Lpf (vgl. Fig. 1) eine Leiterplatten-Abführschiene LA vorgesehen. In der in Fig. 2 dargestellten Stellung des Kreuztisches Kt sind die Leiterplatten-Zuführschienen LZ, die Leiterplatten-Führungsschiene LF und die Leiterplatten-Abführschiene LA fluchtend zueinander ausgerichtet. In Fig. 2 ist ferner auch noch angedeutet, daß die Breite b der Leiterplatten-Zuführschienen LZ, der Leiterplatten-Führungsschiene LF und der Leiterplatten-Abführschiene LA zur Anpassung an verschiedene Leiterplattenformate verstellbar ist.

Werden in den Bestückmodulen Bm1-Bm4 bedrahtete Bauelemente B1-B4 (vgl. Fig. 1) verarbeitet, so werden deren Anschlußdrähte beim Absenken der Bestückköpfe Bk1-Bk4 durch entsprechende Bohrungen der jeweiligen Leiterplatte Lp1-Lp4 gesteckt. Dabei ist Jedem Bestückmodul Bm1-Bm4 ein in Fig. 2 nicht erkennbares Unterwerkzeug zugeordnet, welches die Anschlußdrähte auf die geforderte Länge abschneidet und durch Verbiegen in der jeweiligen Leiterplatte Lp1-Lp4 fixiert.

Erwähnenswert ist an dieser Stelle auch, daß durch den Modulcharakter der eigenständig arbeitenden Bestückmodule Bm1-Bm4 nur geometrisch ähnliche Bauelemente pro Modul verarbeitet werden. Dies führt zu mechanisch einfachen Formen der Bestückköpfe und Unterwerkzeuge, die an die Geometrie der Bauelemente optimal angepaßt werden können.

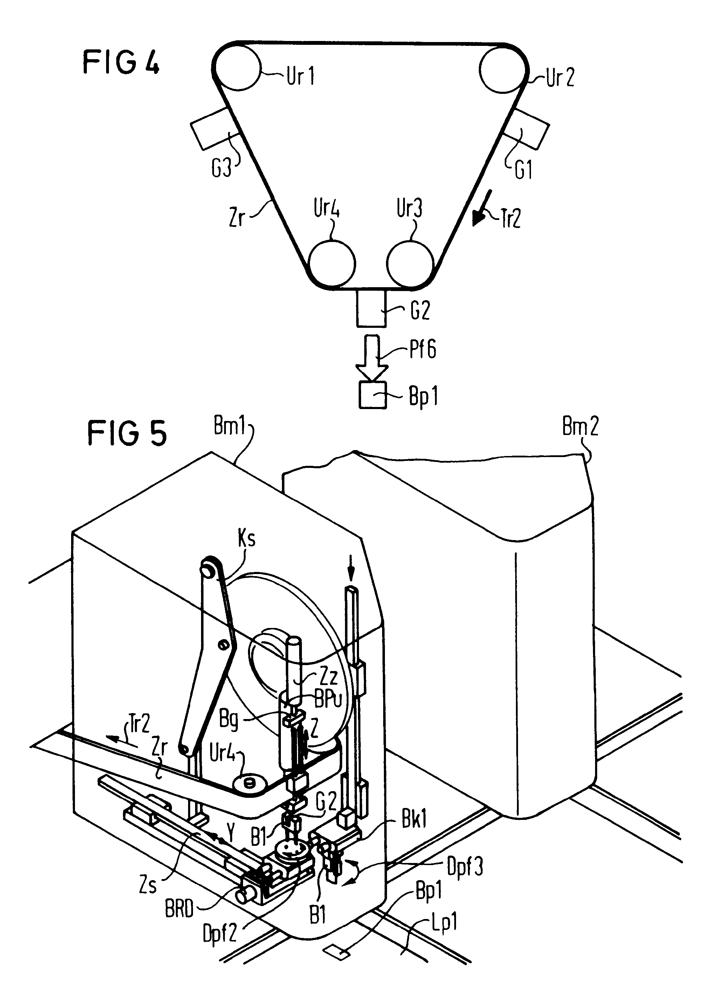

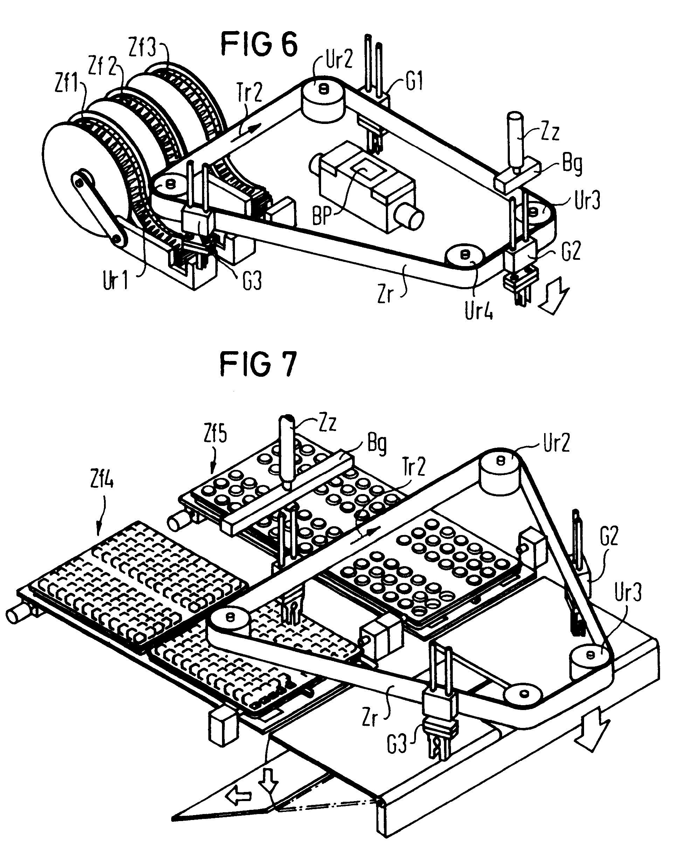

Wie bereits erwähnt wurde, können einem Bestückmodul Bm1-Bm4 auch mehrere geometrisch ähnliche aber elektrisch verschiedene Bauelemente zugeführt werden. Hierzu werden Transporteinrichtungen verwendet, deren Funktionsprinzip nachfolgend anhand der Fig. 3 und 4 erläutert wird.

Gemäß Fig. 3 umfaßt eine derartige Transporteinrichtung einen durch einen Zahnriemen Zr gebildeten endlosen Trieb, der über an den Eckpunkten eines Trapezes angeordnete Umlenkrollen Ur1, Ur2, Ur3 und Ur4 geführt ist und drei im Abstand zueinander angeordnete, zangenförmige Greifer G1, G2 und G3 trägt. Wird eine der Umlenkrollen Ur1-Ur4 auf nicht näher dargestellte Weise angetrieben, so werden die zangenförmigen Greifer G1-G3 in der durch einen Pfeil aufgezeigten Transportrichtung Tr2 verfahren. Im dargestellten Fall befinden sich auf der längeren der beiden parallelen Seiten des Trapezes die in der Zeichnung nicht näher bezeichneten Abholpositionen von Bauelementen aus den Zuführeinrichtungen Zf1, Zf2 und Zf3. Jeder der zangenförmigen Greifer G1-G3 kann jede der Abholpositionen der Zuführeinrichtungen Zf1-Zf3 programmgesteuert anfahren und dort ein entsprechendes Bauelement abholen. Im dargestellten Fall wird mit dem zangenförmigen Greifer G1 die Abholposition der mittleren Zuführeinrichtung Zf2 angefahren, so daß der zangenförmige Greifer G1 dort ein Bauelement aufnehmen kann. Diese Aufnahme eines Bauelements ist durch einen Pfeil Pf5 aufgezeigt. Der zangenförmige Greifer G1 trägt zu diesem Zeitpunkt ein zuvor aus einer der Zuführeinrichtungen Zf1-Zf3 entnommenes Bauelement, während der zangenförmige Greifer G3 zu diesem Zeitpunkt leer ist.

Nach der Aufnahme eines Bauelements durch den zangenförmigen Greifer G1 wird der Zahnriemen Zr wieder in Transportrichtung Tr2 angetrieben und der Greifer G2 fährt dann gemäß Fig. 4 programmgesteuert eine nicht näher bezeichnete Übergabeposition an, die sich im dargestellten Fall in der Mitte zwischen den Umlenkrollen Ur3 und Ur4 befindet. In dieser Übergabeposition übergibt der Greifer G2 das Bauelement beispielsweise an den Bestückkopf Bk1 des Bestückmoduls Bm1 (vgl. Fig. 2), welcher es in einer Bestückposition Bp1 auf der zugeordneten Leiterplatte absetzt. Diese Übergabe des Bauelements ist in Fig. 4 durch einen Pfeil Pf6 angedeutet. Der zangenförmige Greifer G1 trägt zu diesem Zeitpunkt das zuvor aus der Zuführeinrichtung Zf2 entnommene Bauelement, während der Greifer G2 zu diesem Zeitpunkt noch leer ist.

Nach dem vorstehend beschriebenen Übergabevorgang des vom zangenförmigen Greifer G2 transportierten Bauelements an einen Bestückmodul wird der Zahnriemen Zr wieder in Transportrichtung Tr2 angetrieben und der Greifer G3 fährt programmgesteuert eine der Abholpositionen der Zuführeinrichtungen Zf1-Zf3 an und übernimmt ein Bauelement, so wie es zuvor am Beispiel des zangenförmigen Greifers G1 beschrieben wurde.

Auf die vorstehend beschriebene Weise können einem Bestückmodul wahlweise drei geometrisch ähnliche aber elektrisch verschiedene Bauelemente zugeführt werden. Das programmgesteuerte Anfahren der jeweiligen Abholposition bzw. der Übergabeposition erfolgt dabei mit einer äußerst hohen Präzision.

Die in Fig. 4 durch den Pfeil Pf6 lediglich angedeutete Übergabe eines Bauelements an den Bestückkopf Bk1 des Bestückmoduls Bm1 erfolgt gemäß Fig. 5 über eine in den Bestückmodul Bm1 integrierte Bauelement-Richt- und Drehstation BRD. Es ist zu erkennen, daß die Bauelement-Richt- und Drehstation BRD mit einem in Y-Richtung verfahrbaren Zuführschlitten Zs in die Übergabeposition verfahren werden kann, die von dem am Zahnriemen Zr befestigten zangenförmigen Greifer G2 programmgesteuert angefahren wird. Durch Betätigung eines im Bestückmodul Bm1 fest angeordneten Zangenzylinders Zz fährt dessen balkenförmiges Betätigungsglied Bg in Z-Richtung nach unten und bewirkt dadurch eine entsprechende Abwärtsbewegung des zangenförmigen Greifers G2 und die durch einen fest angeordneten Bauelement-Pusher BPu unterstützte Übergabe eines Bauelements B1 an die Bauelement-Richt- und Drehstation BRD. In dieser Station kann das übergebene Bauelement B1 um ± 180° verdreht werden, wobei diese Verdrehmöglichkeit durch einen Doppelpfeil Dpf2 aufgezeigt ist. Nach der Übergabe und einer ggf. vorzunehmenden Verdrehung des Bauelements B1 wird der Zuführschlitten Zs über eine Kurvenschwinge Ks angetrieben und in Y-Richtung nach vorne in die Greifposition des Bestückkopfes Bk1 verfahren. Angetrieben von einer in Figur 5 nicht erkennbaren zweiten Kurvenschwinge fährt der Bestückkopf Bk1 dann nach unten über das Bauelement B1 und ergreift es. In dieser gegriffenen Stellung werden die Anschlußdrähte des Bauelements B1 dann auf übliche Weise, beispielsweise durch plastisches Verbiegen in eine definierte Lage zum Bestückkopf Bk1 des Bestückmoduls Bm1 gebracht. Der Bestückkopf Bk1 entnimmt dann das Bauelement B1 aus der Bauelement-Richt- und Drehstation BRD und positioniert es durch Absenken in Z-Richtung in der Bestückposition Bp1 der Leiterplatte Lp1.

Das vom Bestückkopf Bk1 erfaßte Bauelement B1 kannn mit dem Bestückkopf Bk1 um ± 90° verdreht werden, wobei diese Drehmöglichkeit durch einen Doppelpfeil Dpf 3 aufgezeigt ist. Durch eine Kombination der Drehmöglichkeiten Dpf2 und Dpf3 ist insgesamt eine Verdrehung des Bauelements B1 um 360° in 90°-Schritten möglich.

Fig. 6 zeigt drei nebeneinander angeordnete Zuführeinrichtungen Zf1, Zf2 und Zf3 für axial bedrahtete, gegurtete Bauelelemente. Aus den Abholpositionen dieser drei in üblicher Weise aufgebauten Zuführeinrichtungen Zf1, Zf2 und Zf3 werden die jeweils benötigten Bauelemente von den zangenförmigen Greifern G1, G2 und G3 entnommen und zu der Übergabeposition transportiert, die sich beispielsweise, wie es im Zusammenhang mit Fig. 5 beschrieben wurde, im Bestückmodul Bm1 befindet. Im dargestellten Fall befindet sich gerade der zangenförmige Greifer G2 in dieser Übergabeposition. Es ist auch zu erkennen, daß der Abstand zum nachfolgenden zangenförmigen Greifer G1 derart bemessen ist, daß dieser sich unmittelbar über einer zusätzlichen Station zum Bearbeiten oder Prüfen der Bauelemente befindet, wenn der Greifer G2 die Übergabeposition programmgesteuert anfährt. In dieser zusätzlichen Station BP kann dann beispielsweise eine elektrische Funktionsprüfung der Bauelemente vorgenommen werden.

Fig. 7 zeigt die Bereitstellung von Bauelementen in zwei nebeneinander angeordneten Zuführeinrichtungen Zf4 und Zf5, die als Flächenmagazine ausgebildet sind. Im dargestellten Fall hat der zangenförmige Greifer G1 gerade programmgesteuert eine der Zuführeinrichtung Zf4 zugeordnete Abholposition in X-Richtung angefahren, aus welcher er dann ein entsprechendes Bauelement entnehmen kann. Die Bereitstellung der verschiedenen Bauelemente in den Flächenmagazinen erfolgt durch deren Verschiebung in Y-Richtung. Die Betätigung des zangenförmigen Greifers G2 erfolgt auch hier durch einen ortsfest angeordneten Zangenzylinder Zz, dessen balkenförmiges Betätigungsglied Bg so breit ist, daß es beide den Zuführeinrichtungen Zf4 und Zf5 zugeordnete Abholpositionen überdeckt. In den als Flächenmagazinen ausgebildeten Zuführeinrichtungen Zf4 und Zf5 können beispielsweise Bauelemente wie Transformatoren, Drosseln und dergleichen bereitgestellt werden.

## Patentansprüche

1. Vorrichtung zum Bestücken von Leiterplatten (Lpu, Lp1-Lp4, Lpf) mit Bauelementen (B1-B4), mit
- mindestens zwei im Abstand zueinander angeordneten Bestückmodulen (Bm1-Bm4), die mit Bestückköpfen (Bk1-Bk4) zum Positionieren der Bauelemente (B1-B4) an vorgegebenen Bestückpositionen (Bp1-Bp4) auf den Leiterplatten (Lpu, Lp1-Lp4, Lpf) ausgerüstet sind;
- einer Leiterplatten-Verschiebeeinrichtung, mit welcher sämtliche der den Bestückköpfen (Bk1-Bk4) gleichzeitig zugeordneten Leiterplatten (Lp1-Lp4) simultan in einander entsprechende Bestückpositionen (Bp1-Bp4) verfahren werden; wobei
- ein Bestückkopf (Bk1-Bk4) jeweils dann betätigbar ist, wenn auf der Jeweils zugeordneten Leiterplatte (Lp1-Lp4) eine diesem Bestückkopf (Bk1-Bk4) zugeordnete Bestückposition (Bp1-Bp4) erreicht ist; und mit
- einer Leiterplatten-Transporteinrichtung zum taktweisen Transport der Leiterplatten (Lpu, Lp1-Lp4, Lpf) von Bestückmodul zu Bestückmodul (Bm1-Bm4), wobei bei jedem Takt in Transportrichtung (Tr1) gesehen dem ersten Bestückmodul (Bm1) eine unbestückte Leiterplatte (Lpu) zugeführt wird und vom letzten Bestückmodul (Bm4) eine fertig bestückte Leiterplatte (Lpf) abgeführt wird.

2. Vorrichtung nach Anspruch 1, **dadurch gekennzeichnet,** daß die Leiterplatten-Verschiebeeinrichtung durch einen in zwei zueinander senkrechten Richtungen (X, Y) verschiebbaren Kreuztisch (Kt) gebildet ist.

3. Vorrichtung nach Anspruch 1 oder 2, dadurch gekennzeichnet, daß die Leiterplatten-Transporteinrichtung eine auf der Leiterplatten-Verschiebeeinrichtung angeordnete Leiterplatten-Führungsschiene (LF) sowie den Bestückköpfen (Bk1-Bk4) zugeordnete Takt- und Fixierzangen (TF) umfaßt, welche einerseits die Leiterplatten (Lp1-Lp4) von Bestückmodul zu Bestückmodul (Bm1-Bm4) transportieren und andererseits die Leiterplatten (Lp1-Lp4) während des Bestückvorganges in der Leiterplatten Führungsschiene (LF) halten.

4. Vorrichtung nach einem der vorhergehenden Ansprüche, dadurch gekennzeichnet, daß für die Zufuhr unbestückter Leiterplatten (Lpu) eine Leiterplatten-Zuführschiene (LZ) und für die Abfuhr bestückter Leiterplatten (Lpf) eine Leiterplatten-Abführschiene (LA) vorgesehen sind, wobei in einer vorgebbaren Stellung der Leiterplatten-Verschiebeeinrichtung die Leiterplatten-Zuführschiene (LZ), die Leiterplatten-Führungsschiene (LF) und die Leiterplatten-Abführschiene (LA) fluchtend zueinander ausgerichtet sind.

5. Vorrichtung nach Anspruch 3 oder 4, dadurch gekennzeichnet, daß die Breite (b) der Leiterplatten-Führungsschiene (LF) verstellbar ist.

6. Vorrichtung nach einem der vorhergehenden Ansprüche, gekennzeichnet durch insgesamt auswechselbar angeordnete Bestückmodule (Bm1-Bm4).

7. Vorrichtung nach einem der vorhergehenden Ansprüche, dadurch gekennzeichnet, daß einem Bestückmodul (Bm1-Bm4) mindestens eine Zuführeinrichtung (Zf1-Zf3, Zf4, Zf5) zum Bereitstellen von Bauelementen (B1-B2) in mindestens einer Abholposition zugeordnet ist und daß mindestens ein Transportorgan vorgesehen ist, welches die Bauelemente aus einer Abholposltion entnimmt, zu einer Übergabeposition transportiert und in dieser Übergabeposition an den Bestückkopf (Bk1-Bk4) des Bestückmoduls (Bm1-Bm4) abgibt.

8. Vorrichtung nach Anspruch 7, dadurch gekennzeichnet, daß an einem endlosen Trieb mindestens zwei im Abstand zueinander angeordnete Transportorgane angebracht sind und daß die Abstände dieser Transportorgane derart gewählt sind, daß jede Abholposition und die Übergabeposition von jedem Transportorgan unabhängig voneinander programmgesteuert anfahrbar sind.

9. Vorrichtung nach Anspruch 8, dadurch gekennzeichnet, daß der endlose Trieb durch einen Zahnriemen (Zr) gebildet ist.

10. Vorrichtung nach Anspruch 8 oder 9, dadurch gekennzeichnet, daß die Transportorgane durch relativ zum endlosen Trieb heb- und senkbare zangenförmige Greifer (G1-G3) gebildet sind.

11. Vorrichtung nach einem der Ansprüche 7-10, dadurch gekennzeichnet, daß die Übergabeposition durch eine in den Bestückmodul (Bm1-Bm4) integrierte Bauelement-Richt- und Drehstation (BRD) gebildet ist, in welche die Transportorgane die Bauelemente (B1-B4) absetzen und aus welcher der Bestückkopf (Bk1-Bk4) die Bauelemente (B1-B4) entnimmt.

12. Vorrichtung nach einem der Ansprüche 8-11, dadurch gekennzeichnet, daß an dem endlosen Trieb mindestens drei im Abstand zueinander angeordnete Transportorgane angebracht sind und daß in Transportrichtung (Tr2) des endlosen Triebes gesehen zwischen Abholposition und Übergabeposition eine zusätzliche Station (BP) zum Bearbeiten oder Prüfen der Bauelemente (B1-B4) derart angeordnet ist, daß beim programmgesteuerten Anfahren der Übergabeposition das nachfolgende Transportorgan diese zusätzliche Station (BP) anfährt.

## Claims

1. Apparatus for equipping printed circuit boards (Lpu, Lp1-Lp4, Lpf) with components (B1-B4), having
- at least two equipping modules (Bm1-Bm4), which are arranged at a distance from one another and are furnished with equipping heads (Bk1-Bk4) for positioning the components (B1-B4) at predetermined equipping positions (Bp1-Bp4) on the printed circuit boards (Lpu, Lp1-Lp4, Lpf);
- a printed circuit board displacement device, by means of which all of the printed circuit boards (Lp1-Lp4) simultaneously assigned to the equipping heads (Bk1-Bk4) are moved simultaneously into mutually corresponding equipping positions (Bp1-Bp4);
- it being possible to actuate an equipping bead (Bk1-Bk4) in each case when an equipping position (Bp1-Bp4) assigned to this equipping head (Bk1-Bk4) is reached on the respectively assigned printed circuit board (Lp1-Lp4); and having
- a printed circuit board conveying device for cyclically conveying the printed circuit boards (Lpu, Lp1-Lp4, Lpf) from equipping module to equipping module (Bm1-Bm4), an unequipped printed circuit board (Lpu) being supplied to the first equipping module (Bm1) and an equipped printed circuit board (Lpf) being discharged from the last equipping module (Bm4) during each cycle, both seen in the conveying direction (Tr1).

2. Apparatus according to Claim 1, characterized in that the printed circuit board displacement device is formed by a compound table (Kt) which can be displaced in two mutually perpendicular directions (X, Y).

3. Apparatus according to Claim 1 or 2, characterized in that the printed circuit board conveying device comprises a printed circuit board guide rail (LF), which is arranged on the printed circuit board displacement device, and cycling and fixing nippers (TF), which are assigned to the equipping heads (Bk1-Bk4) and, on the one hand, convey the printed circuit boards (Lp1-Lp4) from equipping module to equipping module (Bm1-Bm4) and, on the other hand, hold the printed circuit boards (Lp1-Lp4) in the printed circuit board guide rail (LF) during the equipping operation.

4. Apparatus according to one of the preceding claims, characterized in that a printed circuit board supply rail (LZ) is provided for supplying unequipped printed circuit boards (Lpu) and a printed circuit board discharge rail (LA) is provided for discharging equipped printed circuit boards (Lpf), the printed circuit board supply rail (LZ), the printed circuit board guide rail (LF) and the printed circuit board discharge rail (LA) being in alignment with one another in a predeterminable position of the printed circuit board displacement device.

5. Apparatus according to Claim 3 or 4, characterized in that the width (b) of the printed circuit board guide rail (LF) is adjustable.

6. Apparatus according to one of the preceding claims, characterized by equipping modules (Bm1-Bm4) which are arranged such that they are, as a whole, interchangeable.

7. Apparatus according to one of the preceding claims, characterized in that at least one supply device (Zf1-Zf3, Zf4, Zf5) for providing components (B1-B2) in at least one collection position is assigned to one equipping module (Bm1-Bm4), and in that at least one conveying element is provided, which removes the components from a collection position, conveys them to a transfer position and, in this transfer position, passes them to the equipping head (Bk1-Bk4) of the equipping module (Bm1-Bm4).

8. Apparatus according to Claim 7, characterized in that at least two conveying elements, arranged at a distance from one another, are fitted to an endless drive, and in that the distances of these conveying elements are selected in such a way that each conveying element can move, independently of one another and under the control of a program, up to each collection position and the transfer position.

9. Apparatus according to Claim 8, characterized in that the endless drive is formed by a toothed belt (Zr).

10. Apparatus according to Claim 8 or 9, characterized in that the conveying elements are formed by nipper-shaped grabbers (G1-G3) which can be raised and lowered relative to the endless drive.

11. Apparatus according to one of Claims 7-10, characterized in that the transfer position is formed by a component directing and rotating station (BRD), which is integrated into the equipping module (Bm1-Bm4) and into which the conveying elements place the components (B1-B4) and from which the equipping head (Bk1-Bk4) removes the components (B1-B4).

12. Apparatus according to one of Claims 8-11, characterized in that at least three conveying elements, arranged at a distance from one another, are fitted to the endless drive, and in that, seen in the conveying direction (Tr2) of the endless drive, there is arranged between the collection position and the transfer position an additional station (BP) for processing or testing the components (B1-B4), in such a way that, during the program-controlled moving up to the transfer position, the following conveying element moves up to this additional station (BP).

## Revendications

1. Dispositif d'équipement de plaquettes à circuits imprimés (Lpu, Lp1 à Lp4, Lpf), de composants (B1 à B4), comportant
- au moins deux modules d'équipement (Bm1 à Bm4), qui sont disposés à distance l'un de l'autre et qui sont munis de têtes d'équipement (Bk1 à Bk4) servant à positionner les composants (B1 à B4) dans des positions prédéterminées d'équipement (Bp1 à Bp4) sur les plaquettes à circuits imprimés (Lpu, Lp1 à Lp4, Lpf);
- un dispositif de déplacement des plaquettes à circuits imprimés, au moyen duquel toutes les plaquettes à circuits imprimés (Lp1 à Lp4), qui sont associées simultanément aux têtes d'équipement (Bk1 à Bk4), sont amenées simultanément dans des positions d'équipement (Bp1 à Bp4) correspondantes;
- une tête d'équipement (Bk1 à Bk4) pouvant être actionnée, lorsque sur la plaquette à circuits imprimés associée (Lp1 à Lp4) une position d'équipement (Bp1 à Bp4), qui est associée à cette tête d'équipement (Bk1 à Bk4) est atteinte; et comportant
- un dispositif de transport des plaquettes à circuits imprimés servant à transporter de façon cadencée les plaquettes à circuits imprimés (Lpu, Lp1 à Lp4, Lpf) d'un module d'équipement à un autre (Bm1 à Bm4), une plaquette à circuits imprimés non équipée (Lpu) étant envoyée, lors de chaque cadence, lorsqu'on regarde dans la direction de transport (Tr1), au premier module d'équipement (Bm1), et une plaquette à circuits imprimés (Lpf), dont l'équipement est terminé, est évacuée du dernier module d'équipement (Bm4).

2. Dispositif suivant la revendication 1, caractérisé par le fait que le dispositif de déplacement des plaquettes à circuits imprimés est formé d'une table (Kt) à mouvements croisés déplaçable dans deux directions (X,Y) perpendiculaires entre elles.

3. Dispositif suivant la revendication 1 ou 2, caractérisé par le fait que le dispositif de transport des plaquettes à circuits imprimés comprend un rail (LF) de guidage des plaquettes à circuits imprimés, qui est disposé sur le dispositif de déplacement des plaquettes à circuits imprimés, ainsi que des pinces de cadencement et de fixation (TF), qui sont associées aux têtes d'équipement (Bk1 à Bk4) et qui d'une part transportent les plaquettes à circuits imprimés (Lp1 à Lp4) d'un module d'équipement à l'autre (Bm1 à Bm4) et d'autre part maintiennent les plaquettes à circuits imprimés (Lp1 à Lp4), pendant l'opération d'équipement, dans le rail (LF) de guidage des plaquettes à circuits imprimés.

4. Dispositif suivant l'une des revendications précédentes, caractérisé par le fait que pour l'amenée de plaquettes à circuits imprimés (Lpu) non équipées, il est prévu un rail (LZ) d'amenée des plaquettes à circuits imprimés et, pour l'évacuation de plaquettes à circuits imprimés équipées (Lpf), il est prévu un rail (LA) d'évacuation des plaquettes à circuits imprimés, le rail (LZ) d'amenée des plaquettes à circuits imprimés, le rail (LF) de guidage des plaquettes à circuits imprimés et le rail (LA) d'évacuation des plaquettes à circuits imprimés étant alignés entre eux, lorsque le dispositif de déplacement des plaquettes à circuits imprimés est dans une position pouvant être prescrite.

5. Dispositif suivant la revendication 3 ou 4, caractérisé par le fait que la largeur (b) du rail (LF) de guidage des plaquettes à circuits imprimés est réglable.

6. Dispositif suivant l'une des revendications précédentes, caractérisé par des modules d'équipement (Bm1 à Bm4) disposés de manière à être globalement interchangeables.

7. Dispositif suivant l'une des revendications précédentes, caractérisé par le fait qu'au moins un dispositif d'amenée (Zf1 à Zf3, Zf4, Zf5) servant à préparer des composants (B1-B2) dans au moins une position de prélèvement est associé à un module d'équipement (Bm1 à Bm4) et qu'il est prévu au moins un organe de transport, qui prélève les composants, d'une position de prélèvement, les transporte jusqu'à une position de transfert et, dans cette position de transfert, les fournit à la tête d'équipement (Bk1 à Bk4) du module d'équipement (Bm1 à Bm4).

8. Dispositif suivant la revendication 7, caractérisé par le fait qu'au moins deux organes de transport distants l'un de l'autre sont disposés sur un élément d'entraînement sans fin et que les distances de ces organes de transport sont choisies de telle sorte que chaque organe de transport puisse passer par la position de prélèvement et par la position de transfert, indépendamment des autres organes de transport, d'une manière commandée par programme.

9. Dispositif selon la revendication 8, caractérisé par le fait que l'élément d'entraînement sans fin est formé d'une courroie dentée (Zr).

10. Dispositif selon la revendication 8 ou 9, caractérisé par le fait que les organes de transport sont formés par des éléments de préhension (G1 à G3) en forme de pinces, qui peuvent être soulevés et abaissés par rapport à l'élément d'entraînement sans fin.

11. Dispositif suivant l'une des revendications 7 à 10, caractérisé par le fait que la position de transfert est formée par un poste (BRD) de direction et de pivotement des composants, qui est intégré au module d'équipement (Bm1 à Bm4) et dans lequel les organes de transport déposent les composants (B1 à B4) et à partir duquel la tête d'équipement (Bk1 à Bk4) prélève les composants (B1 à B4).

12. Dispositif suivant l'une des revendications 8 à 11, caractérisé par le fait qu'au moins trois organes de transfert distants les uns des autres sont disposés sur l'élément d'entraînement sans fin et que, lorsqu'on regarde dans la direction de transport (Tr2) de l'élément d'entraînement sans fin, un poste supplémentaire (BP) servant à traiter ou contrôler les composants (B1 à B4) est disposé entre la position de prélèvement et la position de transfert de telle sorte que, lors du passage, commandé par programme, par la position de transfert, l'organe de transport suivant passe devant ce poste supplémentaire (BP).
